Europäisches Patentamt

European Patent Office

Office européen des brevets

(19)

(11) **EP 1 544 676 A2**

(12) **EUROPÄISCHE PATENTANMELDUNG**

(43) Veröffentlichungstag:
**22.06.2005 Patentblatt 2005/25**

(51) Int Cl.7: **G03F 7/20**

(21) Anmeldenummer: **04029279.9**

(22) Anmeldetag: **10.12.2004**

(84) Benannte Vertragsstaaten:
**AT BE BG CH CY CZ DE DK EE ES FI FR GB GR HU IE IS IT LI LT LU MC NL PL PT RO SE SI SK TR**
Benannte Erstreckungsstaaten:
**AL BA HR LV MK YU**

(30) Priorität:
**15.12.2003 US 734623**
**19.12.2003 US 530623 P**
**22.12.2003 US 530978 P**
**13.02.2004 US 544967 P**
**04.05.2004 US 568006 P**
**27.07.2004 US 591775 P**
**29.07.2004 US 592208 P**
**24.09.2004 US 612823 P**
**22.10.2004 DE 102004051730**

(71) Anmelder: **Carl Zeiss SMT AG**
**73447 Oberkochen (DE)**

(72) Erfinder:
- **Rostalski, Hans-Jürgen**
  **73447 Oberkochen (DE)**
- **Dodoc, Aurelian**
  **73447 Oberkochen (DE)**
- **Epple, Alexander**
  **73431 Aalen (DE)**
- **Beierl, Helmut**
  **89522 Heidenheim (DE)**

(74) Vertreter: **Patentanwälte**
**Ruff, Wilhelm, Beier, Dauster & Partner**
**Kronenstrasse 30**
**70174 Stuttgart (DE)**

(54) **Refraktives Projektionsobjektiv für Immersions-Lithographie**

(57)     Ein für die Immersions-Mikrolithographie geeignetes, rein refraktives Projektionsobjektiv ist als Ein-Taillen-System mit fünf Linsengruppen ausgelegt, bei dem eine erste Linsengruppe mit negativer Brechkraft, eine zweite Linsengruppe mit positiver Brechkraft, eine dritte Linsengruppe mit negativer Brechkraft, eine vierte Linsengruppe mit positiver Brechkraft und eine fünfte Linsengruppe mit positiver Brechkraft vorgesehen sind. Im Bereich der Taille liegt ein Einschnürungsort engster Einschnürung des Strahlungsbündels. Zwischen der Objektebene und dem Einschnürungsort X besteht ein Taillenabstand AT. Für ein Abstandsverhältnis AT/L zwischen dem Taillenabstand AT und einem Objekt-Bildabstand L des Projektionsobjektivs gilt folgende Bedingung: AT/L ≤ 0,4. Ausführungsformen erfindungsgemäßer Projektionsobjektive erreichen sehr hohe numerische Aperturen NA > 1,1 bei großem Bildfeld und zeichnen sich durch eine kompakte Baugröße und eine gute Korrektur des Farbquerfehlers aus.

Fig. 1

**Beschreibung**

Die Erfindung bezieht sich auf ein refraktives Projektionsobjektiv zur Abbildung eines in einer Objektebene des Projektionsobjektivs angeordneten Musters in eine Bildebene des Projektionsobjektives, insbesondere mit Hilfe eines Immersionsmediums, welches zwischen einem letzten optischen Element des Projektionsobjektivs und der Bildebene angeordnet ist.

Photolithographische Projektionsobjektive werden seit mehreren Jahrzehnten zur Herstellung von Halbleiterbauelementen und anderen fein strukturierten Bauteilen verwendet. Sie dienen dazu, Muster von Photomasken oder Strichplatten, die nachfolgend auch als Masken oder Retikel bezeichnet werden, auf einen mit einer lichtempfindlichen Schicht beschichteten Gegenstand mit höchster Auflösung in verkleinerndem Maßstab zu projizieren.

Zur Erzeugung immer feinerer Strukturen in der Größenordnung von 100nm oder darunter tragen vor allem drei parallel verlaufende Entwicklungen bei. Erstens wird versucht, die bildseitige numerische Apertur (NA) der Projektionsobjektive über die derzeit üblichen Werte hinaus in den Bereich von NA = 0,8 oder darüber zu vergrößern. Zweitens werden immer kürzere Wellenlängen von Ultraviolettlicht verwendet, vorzugsweise Wellenlängen von weniger als 260nm, beispielsweise 248nm, 193nm, 157nm oder darunter. Schließlich werden noch andere Maßnahmen zur Auflösungsvergrößerung genutzt, beispielsweise phasenschiebende Masken und/oder schräge Beleuchtung.

Es gibt auch schon Ansätze, die erzielbare Auflösung dadurch zu verbessern, dass in den Raum zwischen dem letzten optischen Element des Projektionsobjektives und dem Substrat ein Immersionsmedium mit hohem Brechungsindex eingebracht wird. Diese Technik wird hier als Immersions-Lithographie bezeichnet. Die hierfür geeigneten Projektionsobjektive werden als Immersionsobjektive oder Immersionssysteme bezeichnet. Durch Einbringung des Immersionsmediums ergibt sich eine effektive Wellenlänge $\lambda_{eff} = \lambda_0/n$, wobei $\lambda_0$ die Vakuum-Arbeitswellenlänge und n der Brechungsindex des Immersionsmediums ist. Daraus ergeben sich eine Auflösung $R = k_1 (\lambda_{eff}/NA_0)$ und eine Schärfentiefe (depth of focus, DOF) $DOF = \pm k_2 (\lambda_{eff}/NA_0^2)$, wobei $NA_0 = \sin\Theta_0$, die "trockene" numerische Apertur und $\Theta_0$ der halbe Öffnungswinkel des Objektives ist. Die empirischen Konstanten $k_1$ und $k_2$ sind prozessabhängig.

Die theoretischen Vorteile der Immersions-Lithographie liegen in der Verringerung der effektiven Arbeitswellenlänge und der damit verbesserten Auflösung. Dies kann bei unveränderter Vakuum-Wellenlänge erreicht werden, so dass für die entsprechende Wellenlänge etablierte Techniken zur Lichterzeugung, zur Wahl von optischen Materialien, zur Beschichtungstechnik etc. weitgehend unverändert übernommen werden können. Allerdings sind Maßnahmen zur Bereitstellung von Projektionsobjektiven mit höchsten numerischen Aperturen im Bereich von NA = 1 oder darüber erforderlich. Weiterhin müssen geeignete Immersionsmedien verfügbar sein.

Für 193nm zeichnet sich Reinstwasser mit $n_1 \approx 1,43$ als geeignetes Immersionsmedium ab.

In dem Artikel "Immersion Lithography at 157nm" von M. Switkes und M. Rothschild, J. Vac. Sci. Technol. B 19(6), Nov./Dec. 2001, Seiten 1ff werden Immersionsflüssigkeiten auf Basis von Perfluorpolyethern (PFPE) vorgestellt, welche für 157nm Arbeitswellenlänge ausreichend transparent und mit einigen derzeit in der Mikrolithographie verwendeten Photoresist-Materialien kompatibel sind. Eine getestete Immersionsflüssigkeit hat bei 157nm einen Brechungsindex $n_l = 1,37$. In der Veröffentlichung ist auch ein mit Kalziumfluorid-Elementen und Silizium-Spiegeln arbeitendes, linsenfreies, optisches System zur Immersions-Interferenz-Lithographie dargestellt, welches bei einer numerischen Apertur von NA = 0,86 die Abbildung von 60nm-Strukturen und darunter ermöglichen soll. Das optische System dürfte für den Einsatz in der Serienproduktion von Halbleitern oder dergleichen nicht geeignet sein.

Die Patentschriften US 4,480,910 und US 5,610,683 (entsprechend EP 0 605 103) beschreiben für die Immersions-Lithographie vorgesehene Projektionsbelichtungsanlagen mit Einrichtungen zur Einbringung von Immersionsfluid zwischen dem Projektionsobjektiv und dem Substrat. Es sind keine Designs für die Projektionsoptik angegeben.

In jüngster Zeit sind einige für die Immersions-Lithografie geeignete Projektionsobjektive bekannt geworden. Die aus den internationalen Patentanmeldungen WO 03/077036 und WO 03/077037 A1 (entsprechend US 2003/3174408) der Anmelderin bekannten rein refraktiven Projektionsobjektive sind als sogenannte Ein-Taillen-Systeme bzw. Zweibauchsysteme mit einem objektnahen Bauch, einem bildnahen Bauch und einer dazwischen liegenden Taille, d.h. einer Einschnürung des Strahlungsbündeldurchmessers, ausgelegt. Dabei wurden bildseitige numerische Aperturen bis zu NA = 1,1 erreicht.

Anstrengungen zur Erreichung noch höherer Aperturen werden dadurch erschwert, dass bei größer werdenden Aperturen die maximalen Linsendurchmesser dramatisch zunehmen, was die Fertigung der Projektionsobjektive kompliziert und teuer macht. Zudem nehmen die Farbfehler, und hier insbesondere der Farbquerfehler, störende Werte an. Der Farbquerfehler (CHV) wird auch als Farbvergrößerungsfehler bezeichnet und bewirkt, dass Teilbilder für unterschiedliche Wellenlängen unterschiedlich groß abgebildet werden. Dies hat zur Folge, dass der Farbquerfehler auf der optischen Achse nicht auftritt, zum Rand des Bildfeldes jedoch immer stärker bemerkbar ist (Feldabhängigkeit).

Üblicherweise werden chromatische Fehler dadurch reduziert, dass innerhalb eines Projektionsobjektivs mindestens zwei optische Materialien mit unterschiedlicher Dispersion eingesetzt werden. Jedoch sind in dem Wellenlängebereich des tiefen Ultraviolettlichts (DUV) bei Arbeitswellenlängen von weniger als 200nm nur wenige transparente optische Materialien mit ausreichend geringer Absorption verfügbar. Für Anwendungen bei 193nm werden hauptsächlich synthetisches Quarzglas ($SiO_2$) als Hauptmaterial und als zweite Materialsorte Fluoridkristallmaterialien, wie Calciumfluorid ($CaF_2$) oder Bariumfluorid ($BaF_2$) verwendet. Bei 157nm wird in der Regel Calciumfluorid als Hauptmaterial und Bariumfluorid als zweites Material genutzt. Jedoch sind die genannten Fluoridkristallmaterialien nur begrenzt verfügbar, teuer und schwer zu bearbeiten. Daher sind optische Designs wünschenswert, die mit nur einer Materialsorte, insbesondere mit synthetischem Quarzglas, auskommen. Die Farbfehler müssen in jedem Fall so minimiert werden, dass bei der Verwendung geeignet schmalbandiger Strahlungsquellen durch die Farbfehler verursachte Kontrastverlust tolerierbar bleiben. Von besonderer Bedeutung ist hier die Korrektion des Farbquerfehlers, da dieser einen feldabhängigen Kontrastverlust erzeugt.

Der Erfindung liegt die Aufgabe zugrunde, ein insbesondere für die Immersions-Lithografie geeignetes, refraktives Projektionsobjektiv bereitzustellen, welches eine kompakte Baugröße hat, mit vertretbarem Materialeinsatz herstellbar ist und einen guten Korrektionszustand für Farbfehler, insbesondere für den Farbquerfehler aufweist.

Diese Aufgabe wird gelöst durch ein Projektionsobjektiv mit den Merkmalen von Anspruch 1. Vorteilhafte Weiterbildungen sind in den abhängigen Ansprüchen angegeben. Der Wortlaut sämtlicher Ansprüche wird durch Bezugnahme zum Inhalt der Beschreibung gemacht.

Gemäß einem Aspekt der Erfindung hat ein refraktives Projektionsobjektiv zur Abbildung eines in einer Objektebene des Projektionsobjektivs angeordneten Musters in die Bildebene des Projektionsobjektivs, insbesondere mit Hilfe eines Immersionsmediums, das zwischen einem letzten optischen Element des Projektionsobjektivs und der Bildebene angeordnet ist,

eine auf die Objektebene folgende erste Linsengruppe mit negativer Brechkraft;

eine darauf folgende zweite Linsengruppe mit positiver Brechkraft;

eine darauf folgende dritte Linsengruppe mit negativer Brechkraft;

eine darauf folgende vierte Linsengruppe mit positiver Brechkraft;

eine darauf folgende fünfte Linsengruppe mit positiver Brechkraft; und

eine Systemblende, die in einem Übergangsbereich von der vierten Linsengruppe zur fünften Linsengruppe angeordnet ist,

so dass ein Ein-Taillen-System mit einem objektseitigen Bauch, einem bildseitigen Bauch und einer zwischen dem objektseitigen Bauch und dem bildseitigen Bauch angeordneten Taille mit einem Einschnürungsort engster Einschnürung eines Strahlungsbündels gebildet ist,

wobei zwischen der Objektebene und dem Einschnürungsort ein Taillenabstand AT besteht und für ein Abstandsverhältnis AT/L zwischen dem Taillenabstand AT und einem Objekt-Bildabstand L des Projektionsobjektivs folgende Bedingung gilt: $AT/L \leq 0,4$.

Die genannte Brechkraftverteilung auf die einzelnen Linsengruppen ergibt ein Projektionsobjektiv mit zwei Bäuchen und einer dazwischen liegenden Taille, wodurch eine gute Korrektur der Bildfeldwölbung erreicht wird (Petzvalkorrektur). Dabei ist der objektseitige Bauch im Verhältnis zur Gesamtbaulänge (Objekt - Bildabstand) L deutlich kürzer als bei bekannten Zweibauchsystemen. Das Abstandsverhältnis AT/L kann insbesondere kleiner als 0,38 oder kleiner als 0,36 oder kleiner als 0,34 sein. Es ist somit günstig, wenn die Taille sehr weit in dem vorderen, objektnahen Bereich des Projektionsobjektivs angeordnet wird.

Der Farbquerfehler ist eine Funktion der Randstrahlhöhe und der Hauptstrahlhöhe sowie der Brechkraft an jeder Linse. Die Randstrahlhöhe ist dabei der senkrechte Abstand eines Randstrahls zur optischen Achse, wobei ein Randstrahl von der Mitte des Objektfeldes zum Blendenrand der für die genutzte numerische Apertur bestimmenden Systemblende führt. Die Hauptstrahlhöhe ist der senkrechte Abstand des Hauptstrahles zur optischen Achse, wobei der Hauptstrahl im Sinne dieser Anmeldung ein Strahl ist, der von einem äußeren Randpunkt des Objektfeldes parallel oder im spitzen Winkel zur optischen Achse verläuft und die optische Achse im Bereich der Systemblende schneidet.

Die Hauptstrahlhöhe ist bei einem Zweibauchsystem (Ein-Taillen-System) im objektseitigen Bauch am größten. Hier haben auch die Randstrahlhöhen einen merklichen Wert. Die Höhe der Hauptstrahlen sollte durch geeignete Wahl der Brechkräfte im objektseitigen Bauch klein gehalten werden. Ein guter Kompromiss für die gleichzeitig zu erfüllenden Forderungen ist dann erreichbar, wenn die Taille weit im vorderen Bereich nahe der Objektebene des Systems angeordnet wird.

Alternativ oder zusätzlich ist es insbesondere für die Korrektion des Farbquerfehlers günstig, wenn ein günstiges Verhältnis der Durchmesser der Bäuche des Systems eingestellt wird. Bei einer Weiterbildung hat der objektseitige Bauch einen ersten Durchmesser D1 und der bildseitige Bauch einen zweiten Durchmesser D3 und für ein Bauchdurchmesserverhältnis D3/D1 gilt: D3/D1 > 1,5. Besonders günstig ist es, wenn das Bauchdurchmesserverhältnis mehr als 1,6 oder mehr als 1,7 beträgt. Ein kleiner Bauchdurchmesser im objektseitigen Bauch korrespondiert mit kleinen Randstrahlhöhen und zusätzlich kleinen Hauptstrahlhöhen im objektseitigen Bauch, aus dem die Hauptbeiträge zum Farbquerfehler kommen.

Gemäß einer Weiterbildung hat die Taille am Einschnürungsort einen Taillendurchmesser D2 und für ein Durchmesserverhältnis D3/D2 zwischen dem Durchmesser des bildseitigen Bauches und dem Taillendurchmesser gilt: D3/D2 ≥ 3. Die Taille ist somit im Vergleich zum bildseitigen zweiten Bauch sehr schlank und hat moderate Randstrahlhöhen. Hierdurch wird unter anderem eine wirksame Korrektur der Bildfeldwölbung erreicht.

Die Hauptbeiträge zum Farbquerfehler stammen aus dem objektseitigen Bauch und werden durch dessen kleinen Durchmesser klein gehalten. Sie können außerdem durch eine geschickte Brechkraftverteilung in der Taille korrigiert werden. Es hat sich gezeigt, dass besonders die ausgangsseitige Linse oder Linsengruppe der dritten Linsengruppe sehr stark korrigierend wirkt. Sie sollte eine deutlich stärkere negative Brechkraft haben als die mindestens eine eingangsseitige Negativlinse der dritten Linsengruppe. Insbesondere kann es günstig sein, wenn in der dritten Linsengruppe vor dem Einschnürungsort eine vordere negative Brechkraft mit Betrag VBK und hinter dem Einschnürungsort eine hintere negative Brechkraft mit Betrag HBK angeordnet ist und für ein Brechkraftverhältnis der Beträge gilt: HBK/VBK ≥ 3.

Besonders günstig ist es, wenn die dritte Linsengruppe eine hintere Negativlinse und mindestens eine vor der hinteren Negativlinse angeordnete vordere Negativlinse umfasst, wobei der Betrag der negativen Brechkraft der hinteren Negativlinse mindestens 20% größer ist als der Betrag der negativen Brechkraft der mindestens einen vorderen Negativlinse der dritten Linsengruppe. Daher sollte die hintere (letzte) Negativlinse der dritten Linsengruppe mit Abstand die höchste negative Brechkraft der Linsen in dieser Gruppe haben. Bei manchen Ausführungsformen ist der Betrag der negativen Brechkraft der hinteren Negativlinse der dritten Linsengruppe mindestens 20% größer, als der Betrag der Gesamtbrechkraft des Projektionsobjektivs. Die negative Brechkraft im Bereich der Taille kann bei Einhaltung dieser Bedingungen eine besonders starke Korrekturwirkung auf den Farbquerfehler ausüben.

Die Korrektur von monochromatischen Aberrationen lässt sich unter der Randbedingung eines minimalen Materialeinsatzes durch den Einsatz asphärischer Flächen optimieren.

Bei einer Ausführungsform enthält die erste Linsengruppe mindestens eine asphärische Fläche, wobei vorzugsweise in der ersten Linsengruppe mindestens zwei asphärische Flächen vorgesehen sind. Eine feldnahe Anordnung von Asphären in einem Bereich, in dem die Hauptstrahlhöhe deutlich größer ist als die Randstrahlhöhe, kann für eine wirksame Verzeichnungskorrektur genutzt werden. Außerdem kann zumindest näherungsweise ein telezentrischer Strahlengang auf der Objektseite erzielt werden. Vorzugsweise enthält die erste Linsengruppe mindestens zwei Linsen mit jeweils einer asphärischen Fläche. Die Verteilung von Asphären auf mehrere Linsen vereinfacht die Herstellung, da große Flächendeformationen vermieden werden können.

Vorzugsweise ist in der zweiten Linsengruppe mindestens eine asphärische Fläche angeordnet, mit der besonders die tangentiale Schale und die Koma wirksam korrigiert werden können. Es ist günstig, eine asphärische Fläche auf der Fläche mit der größten Hauptstrahlhöhe der zweiten Linsengruppe anzuordnen. Bei manchen Ausführungsformen wird die Korrektionswirkung durch die Anordnung von mindestens einer asphärischen Fläche vor und mindestens einer asphärischen Fläche hinter dieser asphärischen Fläche unterstützt.

Es hat sich gezeigt, dass die Korrektur von Koma dadurch verbessert werden kann, wenn in der dritten Linsengruppe und/oder in der vierten Linsengruppe jeweils mindestens eine konkave Fläche als asphärische Fläche gestaltet ist.

Auch in der vierten Linsengruppe und in der fünften Linsengruppe ist vorzugsweise mindestens eine asphärische Fläche vorgesehen. Die asphärischen Flächen in der vierten Linsengruppe und in der fünften Linsengruppe tragen vorrangig zur Korrektur der sphärischen Aberration bei und haben merkliche Beiträge zur Komakorrektion.

Besonders günstig ist es somit, wenn in jeder Linsengruppe mindestens eine asphärische Fläche angeordnet ist.

Bei einer Weiterbildung ist in der vierten Linsengruppe mindestens eine zur Objektebene konkave Meniskuslinse angeordnet. Diese ist vorzugsweise als Negativmeniskuslinse ausgebildet. Sie kann unmittelbar vor der Systemblende im Bereich sehr großer Randstrahlhöhen angeordnet sein. Eine solche Meniskuslinse, insbesondere mit negativer Brechkraft, kann einen wesentlichen Beitrag zur Korrektur der sphärischen Aberration liefern, und zwar im Sinne einer starken Überkorrektion. Damit kann ein großer Teil der sphärischen Unterkorrektion der Linsen hinter der Systemblende, d.h. der Linsen der fünften Linsengruppe, ausgeglichen werden.

Für die Korrekturwirkung ist es günstig, an der konkaven Seite der Meniskuslinse große Einfallswinkel (Inzidenzwinkel) der einfallenden Strahlung zu haben. Vorzugsweise treten an dieser konkaven Fläche die größten Einfallswinkel im gesamten System auf. Große Inzidenzwinkel werden einerseits durch die konkave Form der Fläche unterstützt, auf die bei bevorzugten Ausführungsformen ein zumindest schwach divergentes Strahlungsbündel fällt. Vorzugsweise ist unmittelbar vor der Meniskuslinse mindestens eine Linse mit starker positiver Brechkraft, insbesondere eine Bikonvexlinse, vorgesehen. Durch diese Linse können die Inzidenzwinkel an der nachfolgenden Konkavfläche noch vergrößert werden. Bei bevorzugten Ausführungsformen ist daher in der vierten Linsengruppe mindestens ein Linsendoublett mit mindestens einer, vorzugsweise bikonvexen, Positivlinse und einer unmittelbar nachfolgenden, zur Objektebene konkaven Negativ-Meniskuslinse angeordnet.

Die Systemblende kann eine ebene Systemblende sein, bei der der Blendenrand unabhängig vom eingestellten Blendendurchmesser in einer senkrecht zur optischen Achse stehenden Ebene verbleibt. Bei Systemen mit Blendenfehler kann es günstig sein, wenn die Systemblende einen den Blendendurchmesser bestimmenden Blendenrand hat, dessen axiale Position in Bezug auf die optische Achse des Projektionsobjektivs als Funktion des Blendendurchmessers veränderbar ist. Dies erlaubt eine optimale Anpassung der wirksamen Blendenposition an den Strahlverlauf in Abhängigkeit vom Blendendurchmesser. Die Systemblende kann beispielsweise als Kugelblende ausgebildet sein, bei der der Blendenrand bei Verstellung des Blendendurchmessers entlang einer Kugelfläche verfahrbar ist. Es ist auch möglich, die Systemblende als Kegelblende auszubilden, bei der der Blendenrand bei Verstellung des Blendendurchmessers auf einer Kegelmantelfläche verfahrbar ist. Dies kann beispielsweise durch eine axial verschiebbare ebene Blende erreicht werden.

Erfindungsgemäße Projektionssysteme können für einen weiten Bereich geeigneter Arbeitsabstände bereitgestellt werden. Dabei ist der objektseitige Arbeitsabstand bzw. der Arbeitsabstand im Objektraum der (kleinste) axiale Abstand zwischen der Objektebene und der Eintrittsfläche des Objektivs, während der bildseitige Arbeitsabstand bzw. der Arbeitsabstand im Bildraum der (kleinste) axiale Abstand zwischen der Austrittsfläche des Objektivs und der Bildebene ist. Der Arbeitsabstand im Bildraum, der bei einer Verwendung als Trockensystem mit Gas gefüllt ist, ist bei einer Verwendung als Immersionssystemen während des Betriebs mit einem Immersionsmedium gefüllt.

Bei der Festlegung des Arbeitsabstandes im Bildraum sind bei Immersionssystemen besondere Kriterien zu berücksichtigen. Ein großer Arbeitsabstand bewirkt einerseits sowohl stärkere Strahlungsverluste wegen der üblicherweise niedrigeren Transmission von Immersionsflüssigkeiten (im Vergleich zu Gasen) als auch einen höheren Aberrationsbeitrag der an der Bildebene anliegenden Flächen speziell für die sphärische Aberration. Wenn eine Verwendung als Immersionssystem vorgesehen ist, sollte der bildseitige Arbeitsabstand groß genug sein, um eine laminare Strömung eines Immersionsfluides zuzulassen. Gegebenenfalls sollte auch Raum für Messtechnik und Sensoren vorhanden sein. Bei bevorzugten Ausführungsformen für die Immersions-Lithografie beträgt der bildseitige Arbeitsabstand zwischen ca. 1mm und ca. 15mm, insbesondere zwischen ca. 1,5mm und ca. 5mm.

Ein Mittel, um die Randstrahlhöhen im ersten Bauch klein zu halten, ist die Wahl einer möglichst kleinen numerischen Apertur auf der Objektseite. Dies führt dazu, dass die Randstrahlhöhen im objektseitigen Bauch nicht zu hohe Werte annehmen. Eine kleine objektseitige numerische Apertur kann bei gleichzeitig großer bildseitiger numerischer Apertur durch die Wahl eines günstigen Abbildungsmaßstabes $\beta$ gesteuert werden. Bevorzugte Ausführungsformen sind als Reduktionsobjektive ausgelegt. Der Betrag $|\beta|$ des Abbildungsmaßstabes liegt vorzugsweise im Bereich von 1/6 bis 1/3, insbesondere zwischen 1/5,5 und 1/3,5, so dass insbesondere Verkleinerungen von 5:1 und 4:1 möglich sind.

Bei manchen Ausführungsformen bestehen alle Linsen des Projektionsobjektives aus dem gleichen Material. Als Material kann beispielsweise bei Arbeitswellenlängen von 193nm synthetisches Quarzglas und bei Arbeitswellenlängen von 157nm Kalziumfluorid verwendet werden. Die Verwendung nur einer Materialsorte erleichtert die Herstellung und ermöglicht eine einfache Anpassung des Objektivdesigns an andere Wellenlängen. Es ist auch möglich, mehrere Materialsorten zu kombinieren, um beispielsweise die Korrektur von Farbfehlern zu unterstützen. Auch der Einsatz anderer UV-transparenter Materialien wie $BaF_2$, $NaF$, $LiF$, $SrF$, $MgF_2$ oder dergleichen ist möglich.

Die Erfindung ermöglicht die Konstruktion von Projektionsobjektiven, deren bildseitige numerische Apertur bei Verwendung geeigneter Immersionsmedien $NA \geq 1,0$ beträgt, wobei bei manchen Ausführungsformen auch $NA > 1,1$, insbesondere $NA = 1,2$, $NA = 1,3$ oder darüber möglich sind. Die Projektionsobjektive können an ein Immersionsfluid angepasst sein, welches bei der Arbeitswellenlänge einen Brechungsindex $n_I > 1,3$ hat. Hierdurch kann eine Verringerung der effektiven Arbeitswellenlänge um ca. 30% oder mehr gegenüber Systemen ohne Immersion geschaffen werden.

Die strukturellen Merkmale bevorzugter Ausführungsformen erlauben eine Verwendung des Projektionsobjektivs als Immersionsobjektiv. Erfindungsgemäße Projektionsobjektive sind jedoch auf diese Verwendung nicht beschränkt. Der optische Aufbau erlaubt auch eine Verwendung für die berührungslose Nahfeld-Projektionslithografie. Dabei ist eine Einkopplung von ausreichend Lichtenergie in das zu belichtende Substrat über einen mit Gas gefüllten Spalt möglich, wenn im zeitlichen Mittel ein ausreichend geringer bildseitiger Arbeitsabstand eingehalten wird. Dieser sollte unterhalb des Vierfachen der verwendeten Arbeitswellenlänge liegen, insbesondere unterhalb der Arbeitswellenlänge. Besonders günstig ist es, wenn der Arbeitsabstand weniger als die Hälfte der Arbeitswellenlänge beträgt, beispielsweise weniger als ein Drittel, ein Viertel oder ein Fünftel der Arbeitswellenlänge. Bei diesen kurzen Arbeitsabständen kann eine Abbildung im optischen Nahfeld erfolgen, bei der evaneszente Felder, die in unmittelbarer Nähe der letzten optischen Fläche des Abbildungssystems existieren, zur Abbildung genutzt werden.

Möchte man ein Projektionsobjektiv anstelle der Immersions-Lithografie zur kontaktlosen Nahfeld-Lithografie benutzen, so ist dies durch geringfügige Modifikationen leicht möglich. Hat das Immersionsmedium, an das das optische Design angepasst ist, im Wesentlichen die gleiche Brechzahl wie das letzte optische Element des Objektivs, so wird der Festkörper zur Erzielung eines kleineren bildseitigen Arbeitsabstands dicker gestaltet. Auf diese Weise können z.B. Arbeitsabstände zwischen 20 und 50nm erreicht werden. Gegebenenfalls ist eine optische Nachkorrektur günstig, die beispielsweise mit Hilfe geeigneter Manipulatoren an einem oder mehreren Linsenelementen, beispielsweise zur Verstellung von Luftabständen, durchgeführt werden kann.

Damit umfasst die Erfindung auch ein berührungsloses Projektionsbelichtungsverfahren, bei dem evaneszente Felder des Beliuchtungslichtes, die sich in unmittelbarer Nähe der Austrittsfläche befinden, für den lithografischen Prozess nutzbar gemacht werden. Dabei können bei ausreichend geringen (endlichen) Arbeitsabständen trotz geometrischer Totalreflexionbedingungen an der letzten optischen Fläche des Projektionsobjektivs ein für die Lithografie nutzbarer Lichtanteil aus der Austrittsfläche des Objektives ausgekoppelt und in eine unmittelbar mit Abstand benachbarte Einkoppelfläche eingekoppelt werden.

Ausführungsformen für die kontaktlose Nahfeld-Projektionslithografie haben vorzugsweise typische Arbeitsabstände im Bereich der Arbeitswellenlänge oder darunter, beispielsweise zwischen ca. 3nm und ca. 200nm, insbesondere zwischen ca. 5nm und ca. 100nm. Der Arbeitsabstand sollte an die sonstigen Eigenschaften des Projektionssystems (Eigenschaften des Projektionsobjektivs nahe der Austrittsfläche, Eigenschaften des Substrates nahe der Einkoppelfläche) so angepasst sein, dass im zeitlichen Mittel ein Einkoppelwirkungsgrad von mindestens 10% erzielt wird.

Im Rahmen der Erfindung ist somit ein Verfahren zur Herstellung von Halbleiterbauelementen und dergleichen möglich, bei dem ein endlicher Arbeitsabstand zwischen einer dem Projektionsobjektiv zugeordneten Austrittsfläche für Belichtungslicht und einer dem Substrat zugeordneten Einkoppelfläche für Belichtungslicht eingestellt wird, wobei der Arbeitsabstand innerhalb eines Belichtungszeitintervalles mindestens zeitweise auf einen Wert eingestellt wird, der kleiner ist als eine maximale Ausdehnung eines optischen Nahfeldes des aus der Austrittsfläche austretenden Lichts.

Im übrigen können erfindungsgemäße Projektionsobjektive auch für die konventionelle Projektionslithografie als Trockensysteme verwendet werden. Hierfür kann der bildseitige Arbeitsabstand deutlich größer sein als bei Verwendung als Immersionssystem oder als Nahfeld-Projektionssystem. Da hierbei unter Umständen nicht das volle Potential sehr hoher bildseitiger numerischer Aperturen ausgeschöpft werden kann, kann die Systemblende auf einen kleineren Blendendurchmesser eingestellt werden, um beispielsweise eine genutzte numerische Apertur in der Größenordnung von NA = 0,9 oder NA = 0,8 oder darunter einzustellen.

Die vorstehenden und weitere Merkmale gehen außer aus den Ansprüchen auch aus der Beschreibung und den Zeichnungen hervor, wobei die einzelnen Merkmale jeweils für sich alleine oder zu mehreren in Form von Unterkombinationen bei Ausführungsformen der Erfindung und auf anderen Gebieten verwirklicht sein und vorteilhafte sowie für sich schutzfähige Ausführungen darstellen können. Es zeigen:

Fig. 1    ist ein Linsenschnitt durch eine erste Ausführungsform eines refraktiven Projektionsobjektivs, das für 193nm Arbeitswellenlänge ausgelegt ist;

Fig. 2    ist ein Diagramm, das die relativen Beiträge der einzelnen Linsen zum Farbquerfehler zeigt; und

Fig. 3    ist ein Diagramm, das normierten Brechkräfte der einzelnen Linsen zeigt.

Bei der folgenden Beschreibung bevorzugter Ausführungsformen bezeichnet der Begriff "optische Achse" eine gerade Linie durch die Krümmungsmittelpunkte der optischen Komponenten. Richtungen und Abstände werden als bildseitig oder bildwärts beschrieben, wenn sie in Richtung der Bildebene bzw. des dort befindlichen, zu belichtenden Substrats gerichtet sind und als objektseitig bzw. objektwärts, wenn sie in Bezug auf die optische Achse zum Objekt gerichtet sind. Das Objekt ist in den Beispielen eine Maske (Retikel) mit dem Muster einer integrierten Schaltung, es kann sich aber auch um ein anderes Musters, beispielsweise eines Gitters handeln. Das Bild wird in den Beispielen auf einem als Substrat dienenden, mit einer Photoresistschicht beschichteten Wafer gebildet, jedoch sind auch andere Substrate möglich, beispielsweise Elemente für Flüssigkristallanzeigen oder Substrate für optische Gitter. Die angegebenen Brennweiten sind Brennweiten bezüglich Luft.

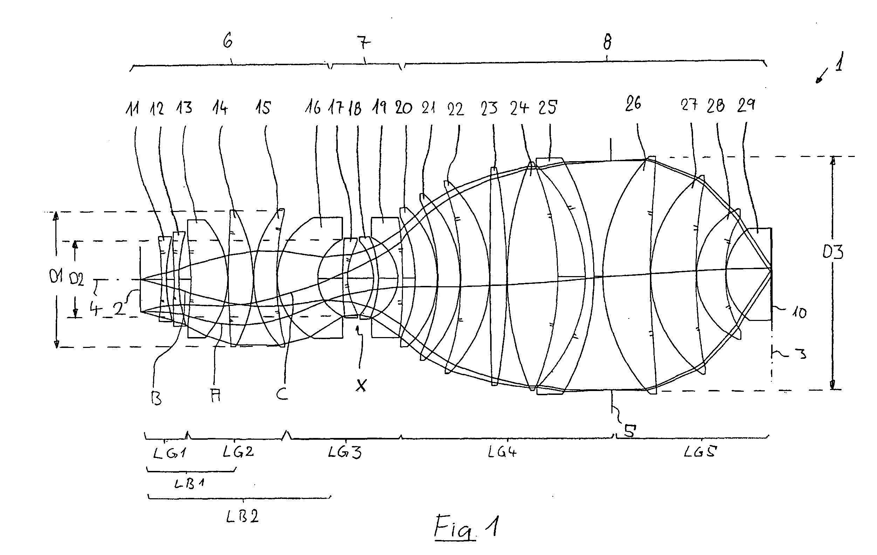

Anhand Fig. 1 wird ein typischer Aufbau einer Ausführungsform eines erfindungsgemäßen, rein refraktiven Reduktionsobjektivs 1 gezeigt. Es dient dazu, bei nahezu homogener Immersion ein in einer Objektebene 2 angeordnetes Muster eines Retikels oder dergleichen in eine Bildebene 3 in reduziertem Maßstab abzubilden, beispielsweise im Maßstab 5:1 (Abbildungsmaßstab β = 0,2). Es handelt sich um ein rotationssymmetrisches Ein-Taillensystem bzw. Zweibauchsystem mit fünf aufeinander folgenden Linsengruppen, die entlang der senkrecht auf Objektebene und Bildebene stehenden optischen Achse 4 angeordnet sind. Die unmittelbar auf die Objektebene 2 folgende erste Linsengruppe LG1 hat negative Brechkraft. Eine unmittelbar darauf folgende zweite Linsengruppe LG2 hat positive Brechkraft. Eine unmittelbar darauf folgende dritte Linsengruppe LG3 hat negative Brechkraft. Eine unmittelbar darauf folgende vierte Linsengruppe hat positive Brechkraft. Eine unmittelbar darauf folgende fünfte Linsengruppe LG5 hat positive Brechkraft. Auf die fünfte Linsengruppe folgt unmittelbar die Bildebene, so dass das Projektionsobjektiv ausser der ersten bis fünften Linsengruppe keine weitere Linse oder Linsengruppe hat. Durch diese Brechkraftverteilung wird ein Zweibauchsystem geschaffen, das einen objektseitigen ersten Bauch 6, einen bildseitigen zweiten Bauch 8 und eine dazwischen liegende Taille 7 hat, in der ein Einschnürungsort X mit minimalem Strahlbündeldurchmesser liegt. In einem Übergangsbereich von der vierten Linsengruppe zur fünften Linsengruppe liegt im Bereich relativ großer Strahldurchmesser die Systemblende 5.

Die mit dem Projektionsobjektiv mögliche Abbildung kann durch den Verlauf ihrer Hauptstrahlen und Randstrahlen gekennzeichnet werden. Als Hauptstrahl A wird hier ein Strahl bezeichnet, der von einem äußeren Randpunkt des Objektfeldes parallel oder in spitzem Winkel zur optischen Achse verläuft und die optische Achse 4 im Bereich der Systemblende 5 schneidet. Ein Randstrahl B führt von der Mitte des Objektfeldes, d.h. von einem axialen Feldpunkt, zum Blendenrand einer Aperturblende, die normalerweise am Ort der Systemblende 5 oder in deren unmittelbarer Nähe sitzt. Ein Strahl C, der von einem äußeren Feldpunkt zum gegenüberliegenden Rand der Aperturblende führt, wird hier als Komastrahl bezeichnet. Der senkrechte Abstand dieser Strahlen zur optischen Achse ergibt die entsprechenden Strahlhöhen $h_A$, $h_B$ und hc

Ein erster Linsenbereich LB1 beginnt an der Objektebene 2 und endet in der Ebene, in der sich der Randstrahl B und der Komastrahl C schneiden, so dass im ersten Linsenbereich LB1 die Bedingung $|h_B/h_C| < 1$ erfüllt ist. In diesem Linsenbereich LB1 ist die Hauptstrahlhöhe gross gegen die Randstrahlhöhe. Hier angeordnete Linsenflächen werden als feldnah bezeichnet. Ein zweiter Linsenbereich LB2 erstreckt sind von der Objektebene 2 bis in den Bereich, in dem die Hauptstrahlhöhe und die Randstrahlhöhe betragsmäßig etwa gleich sind, wobei insbesondere $|h_B/h_A| < 1,2$ gilt. Die Länge des zweiten Linsenbereiches LB2 ist bei typischen Varianten erfindungsgemäßer Projektionssysteme größer als ein Viertel und kleiner als die Hälfte des Abstandes L zwischen Objektebene 2 und Bildebene 3. Dieser Objekt-Bild-Abstand wird auch als Baulänge des Projektionsobjektivs bezeichnet.

Bei typischen Ausführungsformen erfindungsgemäßer Projektionsobjektive hat die ersten Linsengruppe LG1 mindestens zwei Negativlinsen, die zweite Linsengruppe LG2 mindestens drei Positivlinsen, die dritte Linsengruppe LG3 mindestens zwei Negativlinsen, die vierte Linsengruppe LG4 mindestens zwei Positivlinsen und die fünfte Linsengruppe LG5 mindestens drei Positivlinsen.

Die auf die Objektebene 2 folgende erste Linsengruppe LG1 ist im Wesentlichen zuständig für die Aufweitung der Lichtbündel in den ersten, objektseitigen Bauch 6 hinein. Sie hat eine dünne bikonkave Negativlinse 11 mit asphärischer Eintrittsfläche und sphärischer Austrittsfläche und eine darauf folgende, weitere bikonkave Negativlinse 12 mit asphärischer Eintrittsfläche und sphärischer Austrittsfläche. Die feldnah angeordneten Asphären auf den Eintrittsflächen der objektnächsten Linsen 11 und 12 tragen wirksam zur guten Korrektur der Verzeichnung und des Astigmatismus bei. Vor allem sorgen sie für einen näherungsweise telezentrischen Strahlengang auf der Objektseite. Aus fertigungstechnischen Gründen wird es beim Beispielsystem vermieden, die beiden Asphären auf eine einzige Linse zu legen, obwohl dies bei anderen Ausführungsformen möglich ist.

Die zweite Linsengruppe LG2 besteht aus drei Linsen 13, 14, 15. Sie eröffnet mit einer dicken Positiv-Meniskuslinse 13 mit einer asphärischen, objektseitigen Konkavfläche und sphärischer Austrittsfläche. Eine unmittelbar folgende Positivlinse 14 hat eine leicht konvex gewölbte, asphärische Eintrittsfläche und eine sphärische Austrittsfläche. Die folgende Positiv-Meniskuslinse 15 hat eine sphärische Eintrittsfläche und eine asphärische, bildseitig konkave Austrittsfläche. Die asphärische Eintrittsfläche von Linse 14 ist im Bereich größter Hauptstrahlhöhe der zweiten Linsengruppe angeordnet und ist daher besonders wirksam für die Korrektion der tangentialen Schale und von Koma. Die Asphären der davor angeordneten Linse 13 und der dahinter angeordneten Linse 15 unterstützen diese Korrektion.

Die dritte Linsengruppe LG3 besteht aus vier Negativlinsen 16, 17, 18, 19. Eine eintrittsseitige, dicke, bisphärische Meniskuslinse 16 mit bildseitiger Konkavfläche hat schwache negative Brechkraft. Die folgende Meniskuslinse 17 mit schwach gekrümmter, sphärischer Eintrittsfläche und bildseitig konkaver, asphärischer Austrittsfläche liegt im Lichtweg vor dem Einschnürungsort X, in dem das Strahlbündel seinen minimalen Durchmesser im Taillebereich hat. Die Linsen 16, 17 stellen eine vordere negative Brechkraft VBK bereit. Hinter dem Einschnürungsort X folgt eine beidseitig sphärische Negativ-Meniskuslinse 18 mit objektseitiger Konkavfläche. Die letzte Negativ-Linse 19 der dritten Linsengruppe hat eine stark gekrümmte, objektseitig konkave, sphärische Eintrittsfläche und eine schwach gekrümmte, asphärische Austrittsfläche. Die beiden hinteren Negativlinsen 18, 19 stellen gemeinsam eine starke hintere negative Brechkraft HBK bereit. Es hat sich gezeigt, dass die konkave, asphärische Austrittsfläche der Linse 17 wirksam zur Korrektur von Koma beiträgt.

Die vierte Linsengruppe LG4 besteht aus sechs Linsen. Sie umfasst an ihrer Eintrittsseite drei zur Objektebene konkave Positiv-Meniskuslinsen 20, 21, 22, wovon die beiden erstgenannten bisphärisch sind und die im Durchmesser größte Positiv-Meniskuslinse 22 eine zur Objektebene konkave, asphärische Eintrittsfläche hat. Auf die drei Positiv-Meniskuslinsen folgt eine bikonvexe, bisphärische Positivlinse 23 mit schwach gekrümmten Linsenflächen. Im Bereich großer Strahldurchmesser unmittelbar vor der Systemblende 5 ist ein Linsendoublett 24, 25 mit einer eintrittsseitigen Bikonvexlinse 24 starker positiver Brechkraft und einer unmittelbar vor der Systemblende angeordneten Negativ-Meniskuslinse 25 mit objektseitiger, asphärischer Konkavfläche angeordnet. Die einander zugewandten asphärischen Flächen schließen eine zur Objektebene konkave Luftlinse mit der Form einer Positiv-Linse ein. Das Linsendoublett hat eine stark überkorrigierende Wirkung für die sphärische Aberration.

Die hinter der Systemblende 5 liegende fünfte Linsengruppe LG5 ist im Wesentlichen für die Erzeugung der hohen numerischen Apertur verantwortlich. Dazu sind ausschließlich sammelnde Linsen vorgesehen, nämlich drei unmittelbar aufeinander folgende Positiv-Meniskuslinsen 26, 27, 28, die jeweils eine sphärische Eintrittsfläche und eine zur Bildebene konkave, asphärische Austrittsfläche haben, sowie eine abschließende, nicht-hemisphärische Plankonvexlinse 29 mit sphärischer Eintrittsfläche und einer ebenen Austrittsfläche. Die Positivlinsen wirken sphärisch stark unterkorrigierend und betreffend der Koma überkorrigierend.

Die Korrektion der sphärischen Aberration und der Koma wird bei diesem Design wesentlich durch die Balance zwischen dem Linsendoublett 24, 25 unmittelbar vor der Systemblende und den Linsen 26, 27, 28, 29 der fünften Linsengruppe getragen.

Das System hat einen objektseitigen Arbeitsabstand von 32mm bei einer Objektschnittweite von ca. 36,6mm und einen bildseitigen Arbeitsabstand von ca. 2mm, der durch eine Immersionsflüssigkeit 10 ausgefüllt werden kann. Das System ist so ausgelegt, dass als Immersionsflüssigkeit bei 193nm deionisiertes Wasser (Brechungsindex n ≈1,435) oder eine andere geeignete transparente Flüssigkeit mit vergleichbarem Brechungsindex verwendet werden kann.

In Tabelle 1 ist die Spezifikation des Designs in bekannter Weise in tabellarischer Form zusammengefasst. Dabei gibt Spalte 1 die Nummer einer brechenden oder auf andere Weise ausgezeichneten Fläche, Spalte 3 den Radius r der Fläche (in mm), Spalte 4 den als Dicke bezeichneten Abstand d der Fläche zur nachfolgenden Fläche (in mm) und Spalte 5 das Material der optischen Komponenten an. Spalte 6 zeigt den Brechungsindex des Materials und in Spalte 7 sind die nutzbaren, freien Radien bzw. der halbe freie Durchmesser der Linsen (in mm) angegeben. Die Asphärenflächen sind in Spalte 3 mit "AS" gekennzeichnet.

Bei der Ausführungsform sind dreizehn der Flächen asphärisch, nämlich die Flächen 1, 3, 5, 7, 10, 14, 18, 23, 28, 29, 33, 35 und 37. Tabelle 2 gibt die entsprechenden Asphärendaten an, wobei sich die asphärischen Flächen nach folgender Vorschrift berechnen:

$$p(h)=[((1/r)h^2)/(1+SQRT(1-(1+K)(1/r)^2 h^2)]+C1*h^4+C2*h^6+....$$

Dabei gibt der Kehrwert (1/r) des Radius die Flächenkrümmung und h den Abstand eines Flächenpunktes von der optischen Achse (d.h. die Strahlhöhe) an. Somit gibt p(h) die sogenannten Pfeilhöhe, d.h. den Abstand des Flächenpunktes vom Flächenscheitel in z-Richtung, d.h. in Richtung der optischen Achse. Die Konstanten K, C1, C2, ... sind in Tabelle 2 wiedergegeben.

Das mit Hilfe dieser Angaben reproduzierbare optische System 1 ist für eine Arbeitswellenlänge von ca. 193nm ausgelegt, bei der das für alle Linsen verwendete, synthetisches Quarzglas einen Brechungsindex n = 1,5603 hat. Die bildseitige numerische Apertur NA beträgt 1,3. Das objektseitig und bildseitig telezentrische System ist auf einen Brechungsindex des Immersionsmediums 10 von $n_I$ = 1,435 angepasst. Das Objektiv hat eine Baulänge L (Abstand zwischen Bildebene und Objektebene) von ca 1078mm. Bei einer Bildgröße von 22,4mm wird ein Lichtleitwert LLW (Produkt aus numerischer Apertur und Bildgröße) von ca. 29mm erreicht. Die Brennweite Fg des Gesamtsystems beträgt ca. 211 mm.

Der maximale Durchmesser D1 des objektseitigen, ersten Bauchs beträgt 232mm, der Durchmesser D2 am Einschnürungsort X minimalen Strahldurchmessers im Bereich der Taille beträgt 126mm und der maximale Durchmesser D3 des zweiten bildseitigen Bauches beträgt 400mm.

In Tabelle 3 sind für die verschiedenen Linsengruppen und das Gesamtsystem die Werte für die Brennweite f', die Brechkräfte F', die Werte für die Parameter F'/Fg (Brechkraft normiert auf die Gesamtbrechkraft Fg des Objektivs) und F' · LLW sowie für die axiale Länge angegeben.

In Tabelle 4 sind für die einzelnen, in Spalte 1 gekennzeichneten Linsen des Systems die Werte für verschiedene Parameter angegeben. Dabei ist f' die Brennweite, F' die Brechkraft (Kehrwert der Brennweite), LLW der geometrische Lichtleitwert (Etendue), CHV der Wert für den Beitrag der Linse zum Farbquerfehler (CHV-Beitrag) und CHV/CHVm der auf den Maximalwert CHVm normierte, relative CHV-Beitrag der einzelnen Linsen.

Der Farbvergrößerungsfehler CHV ist eine Funktion der Randstrahlhöhe und der Hauptstrahlhöhe sowie der Brechkraft an jeder Linse i. Der Beitrag $CHV_i$ einer jeden Linse ist proportional zur Randstrahlhöhe $h_B$, zur Hauptstrahlhöhe $h_A$ und zur Brechkraft F' und indirekt proportional zur Abbe-Zahl $v_i$ gemäß: $CHV_i \sim h_A \cdot h_B \cdot (F'i/v_i)$

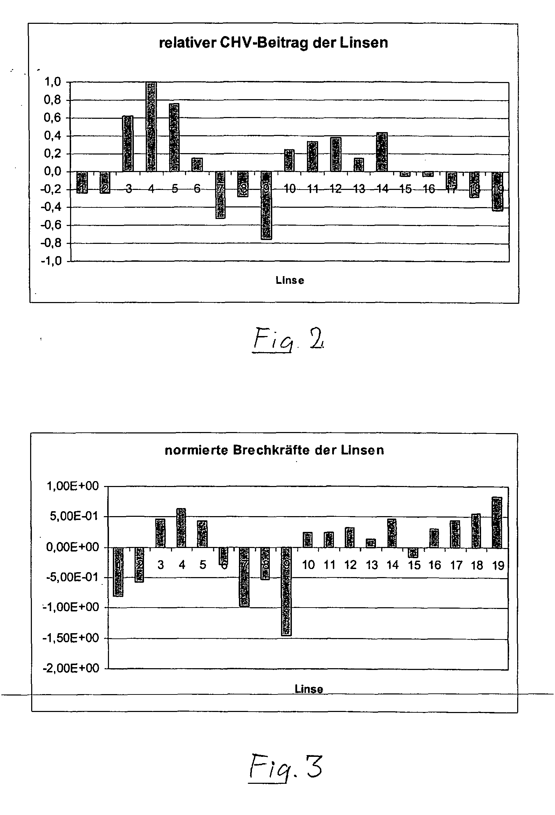

Zur besseren Veranschaulichung der Verteilung relevanter Werte sind in Fig. 2 der relative Beitrag der einzelnen Linsen zum Farbquerfehler (CHV-Beitrag, normiert auf den Maximalwert CHVm bei Linse 4) und in Fig. 3 die auf die Gesamtbrechkraft normierten Brechkräfte (F'/Fg) der Linsen als Funktion der Linsennummer aufgetragen.

Tabelle 5 zeigt für die in Spalte 1 gegebenen Linsenflächen die Sinuswerte sin (i) der Inzidenzwinkel i, die entsprechenden Winkel in Grad und das Verhältnis der sin (i)- Werte zur bildseitigen numerischen Apertur NA. Die sin (i) - Werte entsprechen dem Maximalwert des Sinus des Einfallswinkels bzw. des Brechungswinkels an jeder Fläche. Sie sind also immer in Luft angegeben.

Einige Besonderheiten des Projektionsobjektivs werden im folgenden erläutert. Das Objektiv eröffnet mit zwei asphärisierten Negativlinsen 11, 12, die der Strahlaufweitung und der Korrektur von Verzeichnung und Telezentrie dienen. Aufgrund der relativ geringen objektseitigen numerischen Apertur von $NA_o$ = 0,26 bleiben die Randstrahlhöhen im Eingangsbereich des Projektionsobjektivs moderat. Innerhalb des ersten Bauches 6 wird die maximale Randstrahlhöhe im Bereich des Positiv-Meniskus 15 erreicht und beträgt dort nur 24,3% der maximalen Randstrahlhöhe, die im Bereich der Systemblende 5 erreicht wird. Die maximale Hauptstrahlhöhe wird im Bereich der sphärischen Austrittsfläche der vierten Linse 14 erreicht, wo die Randstrahlhöhe ihren Maximalwert noch nicht erreicht hat. Die maximale Hauptstrahlhöhe beträgt nur 40,8% der maximalen Randstrahlhöhe, welche dem maximalen Blendenradius entspricht. Aufgrund der Proportionalität des CHV-Beitrages zur Randstrahlhöhe und zur Hauptstrahlhöhe wird der maximale CHV-Beitrag von der Linse mit maximaler Hauptstrahlhöhe (Linse 14) erreicht (vgl. Fig. 2).

Die hauptsächlich aus dem ersten Bauch stammenden Beiträge zum Farbvergrößerungsfehler CHV werden durch die nachfolgenden Linsengruppen kompensiert. Besonders wirksam hierfür ist die Konzentration stark negativer Brechkraft unmittelbar vor Eintritt in den objektseitigen Bauch, der mit der vierten Linsengruppe positiver Brechkraft eröffnet. Die stark korrigierende Wirkung der negativen Brechkraft in diesem Bereich am Ausgang der dritten Linsengruppe kann teilweise dadurch erklärt werden, dass hier einerseits die Randstrahlhöhen schon wieder merkliche Werte annehmen und andererseits auch die Hauptstrahlhöhe noch so große Werte hat, dass eine starke Korrekturwirkung auf den Hauptstrahl ausgeübt wird.

Die drei zur Objektebene konkaven Positiv-Meniskuslinsen 20, 21, 22 leiten die Strahlungsbündelzusammenführung nach der maximalen Aufweitung hinter der Negativlinse 19 ein, wobei eine entspannte Strahlführung mit sehr niedrigen Inzidenzwinkeln (Tab. 5) erreicht wird. Gemeinsam mit der nachfolgenden schwach positiven Bikonvexlinse 23 wird sphärische Unterkorrektion eingeführt. Die Negativ-Meniskuslinse 25 unmittelbar vor der Systemblende liefert einen wesentlichen Beitrag zur Korrektur der sphärischen Aberration, und zwar im Sinne einer starken Überkorrektion. Damit wird ein großer Teil der sphärischen Unterkorrektion der Positivlinsen 26 bis 29 der fünften Linsengruppe hinter der Systemblende 5 ausgeglichen. Von großer Bedeutung sind auch die sehr großen Einfallswinkel an der konkaven Eintrittsseite des Meniskus 25. Diese werden einerseits von der starken Krümmung der Konkavseite und andererseits durch die große positive Kraft der Bikonvexlinse unmittelbar vor dem Meniskus erzeugt. An der asphärischen Eintrittsfläche des Negativ-Meniskus 25 treten die größten Einfallswinkel im gesamten System auf. Der maximale Sinus des Inzidenzwinkels liegt bei ca. 99% der bildseitigen numerischen Apertur NA.

Die vier aufeinander folgenden Positivlinsen 26 bis 29 der fünften Linsengruppe LG5 erzeugen die hohe bildseitige numerische Apertur bei moderaten Inzidenzwinkeln und wirken insgesamt sphärisch stark unterkorrigierend sowie bezüglich Koma überkorrigierend. Hierdurch werden die jeweils umgekehrten Beiträge der vierten Linsengruppe vor der Systemblende kompensiert, so dass in der Bildebene 3 nach Durchtritt der Strahlung durch die dünne Immersionsschicht 10 ein hervorragender Korrekturzustand vorliegt.

Die Erfindung betrifft auch eine Projektionsbelichtungsanlage für die Mikrolithographie, die sich dadurch auszeichnet, dass sie ein refraktives Projektionsobjektiv gemäß der Erfindung enthält. Die Projektionsbelichtungsanlage hat vorzugsweise auch Einrichtungen, um zwischen der letzten optischen Fläche des Projektionsobjektivs und dem zu belichtenden Substrat ein Immersionsmedium, beispielsweise eine Flüssigkeit geeigneter Brechzahl, einzubringen und zu halten. Umfasst ist auch ein Verfahren zur Herstellung von Halbleiterbauelementen und anderen fein strukturierten Bauteilen, bei dem ein Bild eines in der Objektebene eines Projektionsobjektivs angeordneten Musters im Bereich der Bildebene abgebildet wird, wobei ein zwischen dem Projektionsobjektiv und dem zu belichtenden Substrat angeordnetes, für Licht der Arbeitswellenlänge transparentes Immersionsmedium durchstrahlt wird.

Tabelle 1

| FLÄCHE | RADIEN | | DICKEN | MATERIAL | BRECHZAHL 193,2nm | ½ FREIER DURCHMESSER |
|---|---|---|---|---|---|---|
| 0 | 0.000000000 | | 36.662040112 | | 1.00000000 | 56.080 |
| 1 | -323.460902261 | AS | 8.038278274 | SIO2HL | 1.56028890 | 65.181 |
| 2 | 267.816434208 | | 13.482406462 | N2VP950 | 1.00000300 | 70.676 |
| 3 | -731.733384848 | AS | 8.004913961 | SIO2HL | 1.56028890 | 72.721 |
| 4 | 280.978130617 | | 20.306990261 | N2VP950 | 1.00000300 | 79.133 |
| 5 | -319.980416314 | AS | 62.121799936 | SIO2HL | 1.56028890 | 82.507 |
| 6 | -153.901726749 | | 1.000000000 | N2VP950 | 1.00000300 | 98.551 |
| 7 | 783.449175169 | AS | 42.497535358 | SIO2HL | 1.56028890 | 112.607 |
| 8 | -243.461838569 | | 1.000000000 | N2VP950 | 1.00000300 | 114.585 |
| 9 | 179.227467379 | | 39.125143879 | SIO2HL | 1.56028890 | 116.001 |

Tabelle 1   (fortgesetzt)

| FLÄCHE | RADIEN | | DICKEN | MATERIAL | BRECHZAHL 193,2nm | ½ FREIER DURCHMESSER |
|---|---|---|---|---|---|---|
| 10 | 480.906878341 | AS | 1.000000000 | N2VP950 | 1.00000300 | 113.279 |
| 11 | 118.324412188 | | 69.486781697 | SIO2HL | 1.56028890 | 101.117 |
| 12 | 73.058237095 | | 42.380894116 | N2VP950 | 1.00000300 | 66.160 |
| 13 | 804.799335653 | | 8.000000000 | SIO2HL | 1.56028890 | 65.718 |
| 14 | 104.005737015 | AS | 44.110760436 | N2VP950 | 1.00000300 | 62.994 |
| 15 | -98.848204915 | | 8.000000000 | SIO2HL | 1.56028890 | 63.113 |
| 16 | -182.724753260 | | 33.646618163 | N2VP950 | 1.00000300 | 68.253 |
| 17 | -76.124405725 | | 8.000000000 | SIO2HL | 1.56028890 | 68.955 |
| 18 | -1194.521750855 | AS | 21.838763844 | N2VP950 | 1.00000300 | 100.434 |
| 19 | -226.579410865 | | 38.146641402 | SIO2HL | 1.56028890 | 103.971 |
| 20 | -164.064155469 | | 1.000000000 | N2VP950 | 1.00000300 | 116.815 |
| 21 | -306.672815568 | | 38.446849323 | SIO2HL | 1.56028890 | 132.820 |
| 22 | -195.444904770 | | 1.000000000 | N2VP950 | 1.00000300 | 139.642 |
| 23 | -566.123511009 | AS | 49.471751921 | SIO2HL | 1.56028890 | 156.750 |
| 24 | -229.513378771 | | 1.000000000 | N2VP950 | 1.00000300 | 161.797 |
| 25 | 7198.266735077 | | 28.157625168 | SIO2HL | 1.56028890 | 181.779 |
| 26 | -1068.929463970 | | 1.000000000 | N2VP950 | 1.00000300 | 183.468 |
| 27 | 512.804453822 | | 85.879726018 | SIO2HL | 1.56028890 | 192.485 |
| 28 | -489.298237991 | AS | 48.000806847 | N2VP950 | 1.00000300 | 192.048 |
| 29 | -255.199113275 | AS | 15.204316739 | SIO2HL | 1.56028890 | 190.697 |
| 30 | -408.017115393 | | 30.694150369 | N2VP950 | 1.00000300 | 198.843 |
| 31 | 0.000000000 | | -14.622598208 | N2VP950 | 1.00000300 | 196.692 |
| 32 | 299.575126721 | | 81.075589692 | SIO2HL | 1.56028890 | 199.963 |
| 33 | 1234.064936323 | AS | 1.043659212 | N2VP950 | 1.00000300 | 196.087 |
| 34 | 211.382655255 | | 76.486237035 | SIO2HL | 1.56028890 | 166.835 |
| 35 | 945.579070441 | AS | 1.000000000 | N2VP950 | 1.00000300 | 160.232 |
| 36 | 124.953815758 | | 49.441802491 | SIO2HL | 1.56028890 | 109.457 |
| 37 | 254.183893856 | AS | 1.000000000 | N2VP950 | 1.00000300 | 97.120 |
| 38 | 99.333101280 | | 76.128099196 | SIO2HL | 1.56028890 | 76.544 |
| 39 | 0.000000000 | | 1.998587231 | IMMERS | 1.43500000 | 15.560 |
| 40 | 0.000000000 | | 0.000000000 | | 1.00000000 | 11.216 |

**Tabelle 2**

## ASPHÄRISCHE KONSTANTEN

| FLÄCHE NR. 1 | |
|---|---|
| K | 00000 |
| C1 | 371267043e-007 |
| C2 | -882594301e-011 |
| C3 | 118826876e-014 |
| C4 | -287728419e-018 |
| C5 | 555321666e-022 |
| C6 | -549582739e-026 |
| C7 | 243863873e-030 |
| C8 | 000000000e+000 |
| C9 | 000000000e+000 |

| FLÄCHE NR. 10 | |
|---|---|
| K | 00000 |
| C1 | -965366426e-009 |
| C2 | 122772701e-014 |
| C3 | 142388685e-016 |
| C4 | -103892528e-020 |
| C5 | 318262087e-025 |
| C6 | 328954553e-031 |
| C7 | -240623653e-034 |
| C8 | 000000000e+000 |
| C9 | 000000000e+000 |

| FLÄCHE NR. 3 | |
|---|---|
| K | 00000 |
| C1 | -165739114e-007 |
| C2 | 691478272e-011 |
| C3 | -456133228e-015 |
| C4 | 952019196e-019 |
| C5 | -266949578e-022 |
| C6 | 263539717e-026 |
| C7 | -878182245e-031 |
| C8 | 000000000e+000 |
| C9 | 000000000e+000 |

| FLÄCHE NR. 14 | |
|---|---|
| K | 00000 |
| C1 | -215298945e-007 |
| C2 | -726837025e-012 |
| C3 | -219233406e-015 |
| C4 | 190729935e-019 |
| C5 | -143595848e-022 |
| C6 | 293973219e-026 |
| C7 | -394266384e-030 |
| C8 | 000000000e+000 |
| C9 | 000000000e+000 |

| FLÄCHE NR. 5 | |
|---|---|
| K | 00000 |
| C1 | 151725747e-007 |
| C2 | -569441977e-012 |
| C3 | -806484964e-016 |
| C4 | 160003519e-019 |
| C5 | 582581254e-024 |
| C6 | -281650392e-027 |
| C7 | 189184398e-031 |
| C8 | 000000000e+000 |
| C9 | 000000000e+000 |

| FLÄCHE NR. 18 | |
|---|---|
| K | 00000 |
| C1 | -357912507e-011 |
| C2 | -412582474e-012 |
| C3 | 373943565e-016 |
| C4 | -257921060e-020 |
| C5 | 961326142e-025 |
| C6 | -958283316e-030 |
| C7 | -419939024e-034 |
| C8 | 000000000e+000 |
| C9 | 000000000e+000 |

| FLÄCHE NR. 7 | |
|---|---|
| K | 00000 |
| C1 | -451804621e-008 |
| C2 | 105687249e-012 |
| C3 | 968348619e-017 |
| C4 | -784284075e-021 |
| C5 | 206431753e-025 |
| C6 | 548912115e-030 |
| C7 | -385059319e-034 |
| C8 | 000000000e+000 |
| C9 | 000000000e+000 |

| FLÄCHE NR. 23 | |
|---|---|
| K | 00000 |
| C1 | -648378589e-009 |
| C2 | -430629472e-015 |
| C3 | -125331200e-018 |
| C4 | -256831146e-023 |
| C5 | -209613588e-027 |
| C6 | 260560345e-032 |
| C7 | -105170270e-036 |
| C8 | 000000000e+000 |
| C9 | 000000000e+000 |

**Tabelle 2 (Fortsetzung)**

| FLÄCHE NR. 28 | |
|---|---|
| K | 00000 |
| C1 | -478746317e-010 |
| C2 | 539031101e-014 |
| C3 | -368539150e-019 |
| C4 | -518299349e-024 |
| C5 | -194271919e-028 |
| C6 | 354630998e-033 |
| C7 | 103993691e-038 |
| C8 | 000000000e+000 |
| C9 | 000000000e+000 |

| FLÄCHE NR. 35 | |
|---|---|
| K | 00000 |
| C1 | -368190267e-009 |
| C2 | 293519295e-013 |
| C3 | -299249062e-018 |
| C4 | 271670797e-023 |
| C5 | -789821541e-028 |
| C6 | 220097667e-032 |
| C7 | -595782128e-038 |
| C8 | 000000000e+000 |
| C9 | 000000000e+000 |

| FLÄCHE NR. 29 | |
|---|---|
| K | 00000 |
| C1 | -711087855e-011 |
| C2 | 670292603e-014 |
| C3 | -338818049e-019 |
| C4 | 148875707e-023 |
| C5 | -561629567e-028 |
| C6 | 160959953e-032 |
| C7 | -803319076e-038 |
| C8 | 000000000e+000 |
| C9 | 000000000e+000 |

| FLÄCHE NR. 37 | |
|---|---|
| K | 00000 |
| C1 | 516064461e-008 |
| C2 | 995673600e-013 |
| C3 | 262156131e-017 |
| C4 | 276881057e-021 |
| C5 | 168223005e-025 |
| C6 | -138684760e-029 |
| C7 | 142262160e-033 |
| C8 | 000000000e+000 |
| C9 | 000000000e+000 |

| FLÄCHE NR. 33 | |
|---|---|
| K | 00000 |
| C1 | -475159499e-009 |
| C2 | 488790782e-014 |
| C3 | -166792427e-018 |
| C4 | 452942489e-023 |
| C5 | -744726495e-028 |
| C6 | 699564479e-033 |
| C7 | -286675157e-038 |
| C8 | 000000000e+000 |
| C9 | 000000000e+000 |

Tabelle 3

| | LG1 | LG2 | LG3 | LG4 | LG5 | Gesamt Fg |
|---|---|---|---|---|---|---|
| Brennweiten | -1,47E+02 | 1,36E+02 | -5,68E+01 | 1,73E+02 | 1,21E+02 | 2,11E+02 |
| Brechkräfte | -6,82E-03 | 7,35E-03 | -1,76E-02 | 5,79E-03 | 8,29E-03 | 4,73E-03 |
| F'/Fg | -1,44E+00 | 1,55E+00 | -3,72E+00 | 1,22E+00 | 1,75E+00 | 1,00E+00 |
| F'*LLW | -1,99E-01 | 2,14E-01 | -5,13E-01 | 1,69E-01 | 2,41E-01 | |

Tabelle 3   (fortgesetzt)

|  | LG1 | LG2 | LG3 | LG4 | LG5 | Gesamt Fg |
|---|---|---|---|---|---|---|
| axiale Länge | 2,95E+01 | 1,46E+02 | 2,14E+02 | 3,07E+02 | 2,88E+02 |  |
| Linsen | 11-12 | 13-15 | 16-19 | 20-25 | 26-29 |  |

Tabelle 4

| Flächen | f | F' | IF'I | IF'I*LLW | F'/Fg | CHV | CHV/ CHVmax |
|---|---|---|---|---|---|---|---|
| F1..2) | -2,60E+02 | -3,84E-03 | 3,84E-03 | 1,12E-01 | -8,11E-01 | -5,00E-06 | -2,38E-01 |
| F3..4) | -3,61 E+02 | -2,77E-03 | 2,77E-03 | 8,06E-02 | -5,85E-01 | -5,00E-06 | -2,38E-01 |
| F5..6) | 4,67E+02 | 2,14E-03 | 2,14E-03 | 6,24E-02 | 4,52E-01 | 1,30E-05 | 6,19E-01 |
| F7..8) | 3,36E+02 | 2,97E-03 | 2,97E-03 | 8,66E-02 | 6,28E-01 | 2,10E-05 | 1.00E+00 |
| F9..10) | 4,87E+02 | 2,05E-03 | 2,05E-03 | 5,98E-02 | 4,34E-01 | 1,60E-05 | 7,62E-01 |
| F11..12) | -7,58E+02 | -1,32E-03 | 1,32E-03 | 3,84E-02 | -2,78E-01 | 3,00E-06 | 1,43E-01 |
| F13..14) | -2,14E+02 | -4,67E-03 | 4,67E-03 | 1,36E-01 | -9,87E-01 | -1,10E-05 | -5,24E-01 |
| F15..16) | -3,98E+02 | -2,51E-03 | 2,51E-03 | 7,32E-02 | -5,31E-01 | -6,00E-06 | -2,86E-01 |
| F17..18) | -1,45E+02 | -6,87E-03 | 6,87E-03 | 2,00E-01 | -1,45E+00 | -1,60E-05 | -7,62E-01 |
| F19..20) | 8,71E+02 | 1,15E-03 | 1,15E-03 | 3,35E-02 | 2,43E-01 | 5,00E-06 | 2,38E-01 |
| F21..22) | 8,56E+02 | 1,17E-03 | 1,17E-03 | 3,40E-02 | 2,47E-01 | 7,00E-06 | 3,33E-01 |
| F23..24) | 6,54E+02 | 1,53E-03 | 1,53E-03 | 4,45E-02 | 3,23E-01 | 8,00E-06 | 3,81E-01 |
| F25..26) | 1,66E+03 | 6,01 E-04 | 6,01 E-04 | 1,75E-02 | 1,27E-01 | 3,00E-06 | 1,43E-01 |
| F27..28) | 4,61 E+02 | 2,17E-03 | 2,17E-03 | 6,32E-02 | 4,58E-01 | 9,00E-06 | 4,29E-01 |
| F29..30) | -1,26E+03 | -7,93E-04 | 7,93E-04 | 2,31 E-02 | -1,67E-01 | -1,00E-06 | -4,76E-02 |
| F32..33) | 6,85E+02 | 1,46E-03 | 1,46E-03 | 4,25E-02 | 3,08E-01 | -1,00E-06 | -4,76E-02 |
| F34..35) | 4,68E+02 | 2,14E-03 | 2,14E-03 | 6,22E-02 | 4,51E-01 | -4,00E-06 | -1,90E-01 |
| F36..37) | 3,86E+02 | 2,59E-03 | 2,59E-03 | 7,55E-02 | 5,48E-01 | -6,00E-06 | -2,86E-01 |
| F38..39) | 2,54E+02 | 3,93E-03 | 3,93E-03 | 1,14E-01 | 8,30E-01 | -9,00E-06 | -4,29E-01 |

Tabelle 5

| FLÄCHE | sin (i) | (i) [ ° ] | sin (i) / NA |
|---|---|---|---|
| 0 | 0,26 | 15,07 | 0,29 |
| 1 | 0,343 | 20,06 | 0,38 |
| 2 | 0,761 | 49,55 | 0,84 |
| 3 | 0,675 | 42,46 | 0,75 |
| 4 | 0,869 | 60,34 | 0,96 |
| 5 | 0,686 | 43,32 | 0,76 |
| 6 | 0,409 | 24,14 | 0,45 |
| 7 | 0,367 | 21,53 | 0,41 |

Tabelle 5  (fortgesetzt)

| FLÄCHE | sin (i) | (i) [ ° ] | sin (i) / NA |
|---|---|---|---|
| 8 | 0,453 | 26,94 | 0,50 |
| 9 | 0,662 | 41,45 | 0,73 |
| 10 | 0,264 | 15,31 | 0,29 |
| 11 | 0,687 | 43,39 | 0,76 |
| 12 | 0,834 | 56,51 | 0,92 |
| 13 | 0,406 | 23,95 | 0,45 |
| 14 | 0,595 | 36,51 | 0,66 |
| 15 | 0,618 | 38,17 | 0,68 |
| 16 | 0,345 | 20,18 | 0,38 |
| 17 | 0,785 | 51,72 | 0,87 |
| 18 | 0,776 | 50,90 | 0,86 |
| 19 | 0,573 | 34,96 | 0,63 |
| 20 | 0,16 | 9,21 | 0,18 |
| 21 | 0,41 | 24,21 | 0,45 |
| 22 | 0,306 | 17,82 | 0,34 |
| 23 | 0,281 | 16,32 | 0,31 |
| 24 | 0,483 | 28,88 | 0,53 |
| 25 | 0,406 | 23,95 | 0,45 |
| 26 | 0,126 | 7,24 | 0,14 |
| 27 | 0,608 | 37,45 | 0,67 |
| 28 | 0,65 | 40,54 | 0,72 |
| 29 | 0,895 | 63,51 | 0,99 |
| 30 | 0,51 | 30,66 | 0,56 |
| 32 | 0,706 | 44,91 | 0,78 |
| 33 | 0,367 | 21,53 | 0,41 |
| 34 | 0,503 | 30,20 | 0,56 |
| 35 | 0,584 | 35,73 | 0,64 |
| 36 | 0,276 | 16,02 | 0,30 |
| 37 | 0,586 | 35,87 | 0,65 |
| 38 | 0,364 | 21,35 | 0,40 |
| 39 | 0,836 | 56,72 | 0,92 |
| 40 | 0,906 | 64,96 | 1,00 |

**Patentansprüche**

1. Refraktives Projektionsobjektiv zur Abbildung eines in einer Objektebene des Projektionsobjektivs angeordneten Musters in eine Bildebene des Projektionsobjektivs, insbesondere mit Hilfe eines Immersionsmediums, welches zwischen einem letzten optischen Element des Projektionsobjektives und der Bildebene angeordnet ist, mit:

   einer auf die Objektebene folgenden ersten Linsengruppe (LG1) mit negativer Brechkraft;

einer auf die erste Linsengruppe folgende zweite Linsengruppe (LG2) mit positiver Brechkraft;

einer auf die zweite Linsengruppe folgende dritte Linsengruppe (LG3) mit negativer Brechkraft;

einer auf die dritte Linsengruppe folgende vierte Linsengruppe (LG4) mit positiver Brechkraft;

einer auf die vierte Linsengruppe folgende fünfte Linsengruppe (LG5) mit positiver Brechkraft; und

einer Systemblende (5), die in einem Übergangsbereich von der vierten Linsengruppe zur fünften Linsengruppe angeordnet ist,

so dass ein Ein-Taillen-System mit einem objektseitigen Bauch (6), einem bildseitigen Bauch (8) und einer zwischen dem objektseitigen Bauch und dem bildseitigen Bauch angeordneten Taille (7) mit einem Einschnürungsort (X) engster Einschnürung eines Strahlungsbündels gebildet ist,

wobei zwischen der Objektebene und dem Einschnürungsort ein Taillenabstand AT besteht und für ein Abstandsverhältnis AT/L zwischen dem Taillenabstand AT und einem Objekt-Bildabstand L des Projektionsobjektivs folgende Bedingung gilt: $AT/L \leq 0{,}4$.

2. Projektionsobjektiv nach Anspruch 1, bei dem der objektseitige Bauch (6) einen ersten Durchmesser D1 und der bildseitige Bauch (8) einen zweiten Durchmesser D3 hat und für ein Bauchdurchmesserverhältnis D3/D1 gilt: $D3/D1 > 1{,}5$.

3. Projektionsobjektiv nach Anspruch 1 oder 2, bei dem die Taille (7) am Einschnürungsort (X) einen Taillendurchmesser D2 hat und für ein Durchmesserverhältnis D3/D2 zwischen dem Durchmesser des bildseitigen Bauches und dem Taillendurchmesser gilt: $D3/D2 \geq 3$.

4. Projektionsobjektiv nach einem der vorhergehenden Ansprüche, bei dem in der dritten Linsengruppe (LG3) vor dem Einschnürungsort (X) eine vordere negative Brechkraft mit Betrag VBK und hinter dem Einschnürungsort eine hintere negative Brechkraft mit Betrag HBK angeordnet ist und für ein Brechkraftverhältnis der Beträge gilt: $HBK/VBK \geq 3$.

5. Projektionsobjektiv nach einem der vorhergehenden Ansprüche, bei dem die dritte Linsengruppe (LG3) eine hintere Negativlinse (19) und mindestens eine vor der hinteren Negativlinse angeordnete vordere Negativlinse (16, 17, 18) umfasst, wobei der Betrag der negativen Brechkraft der hinteren Negativlinse mindestens 20% größer ist als der Betrag der negativen Brechkraft der mindestens einen vorderen Negativlinse.

6. Projektionsobjektiv nach einem der vorhergehenden Ansprüche, bei dem die dritte Linsengruppe (LG3) eine hintere Negativlinse (19) und mindestens eine vor der hinteren Negativlinse angeordnete vordere Negativlinse (16, 17, 18) umfasst, wobei der Betrag der negativen Brechkraft der hinteren Negativlinse mindestens 20% größer ist als der Betrag der Gesamtbrechkraft des Projektionsobjektivs.

7. Projektionsobjektiv nach einem der vorhergehenden Ansprüche, bei dem die erste Linsengruppe (LG1) mindestens eine asphärische Fläche enthält, wobei vorzugsweise in der ersten Linsengruppe mindestens zwei asphärische Flächen vorgesehen sind.

8. Projektionsobjektiv nach einem der vorhergehenden Ansprüche, bei dem die erste Linsengruppe (LG1) mindestens zwei Linsen (11, 12) mit jeweils einer asphärischen Fläche enthält.

9. Projektionsobjektiv nach einem der vorhergehenden Ansprüche, bei dem in der zweiten Linsengruppe (LG2) mindestens eine asphärische Fläche angeordnet,

10. Projektionsobjektiv nach Anspruch 9, bei dem die asphärische Fläche im Bereich der Fläche mit der größten Hauptstrahlhöhe der zweiten Linsengruppe angeordnet ist.

11. Projektionsobjektiv nach einem der vorhergehenden Ansprüche, bei dem in der dritten Linsengruppe (LG3) und/ oder in der vierten Linsengruppe (LG4) jeweils mindestens eine konkave Fläche als asphärische Fläche gestaltet ist.

12. Projektionsobjektiv nach einem der vorhergehenden Ansprüche, bei dem in der dritten Linsengruppe (LG3) mindestens eine asphärische Fläche vorgesehen ist, wobei vorzugsweise zwei asphärische Flächen vorgesehen sind.

13. Projektionsobjektiv nach einem der vorhergehenden Ansprüche, bei dem in jeder Linsengruppe mindestens eine asphärische Fläche angeordnet ist.

14. Projektionsobjektiv nach einem der vorhergehenden Ansprüche, bei dem die zweite Linsengruppe (LG2) mindestens zwei, vorzugsweise mindestens drei aufeinander folgende Linsen mit positiver Brechkraft aufweist.

15. Projektionsobjektiv nach einem der vorhergehenden Ansprüche, bei dem die zweite Linsengruppe (LG2) mindestens eine zur Bildebene konkave Meniskuslinse mit positiver Brechkraft aufweist.

16. Projektionsobjektiv nach einem der vorhergehenden Ansprüche, bei dem die dritte Linsengruppe (LG3) nur Linsen mit negativer Brechkraft aufweist.

17. Projektionsobjektiv nach einem der vorhergehenden Ansprüche, bei dem die vierte Linsengruppe (LG4) in einem objektseitigen Eintrittsbereich mindestens eine zur Objektebene (2) konkave Meniskuslinse mit positiver Brechkraft aufweist, wobei vorzugsweise aufeinanderfolgend mehrere derartige Meniskuslinsen (20, 21, 22) vorgesehen sind.

18. Projektionsobjektiv nach einem der vorhergehenden Ansprüche, bei dem in der vierten Linsengruppe (LG4) mindestens eine zur Objektebene konkave Meniskuslinse (25) angeordnet ist.

19. Projektionsobjektiv nach Anpruch 18, bei dem die Meniskuslinse als Negativ-Meniskuslinse (25) ausgebildet ist.

20. Projektionsobjektiv nach einem der Ansprüche 18 oder 19, bei dem die Meniskuslinse (25) unmittelbar vor der Systemblende (5) im Bereich großer Randstrahlhöhen angeordnet ist.

21. Projektionsobjektiv nach einem Ansprüche 18 bis 20, bei dem an der konkaven Fläche der Meniskuslinse die größten Inzidenzwinkel der einfallenden Strahlung im gesamten Projektionsobjektiv auftreten.

22. Projektionsobjektiv nach einem Ansprüche 18 bis 21, bei dem unmittelbar vor der Meniskuslinse (25) mindestens eine Linse (24) mit starker positiver Brechkraft, insbesondere eine Bikonvexlinse, angeordnet ist.

23. Projektionsobjektiv nach einem der vorhergehenden Ansprüche, bei dem in der vierten Linsengruppe (LG4) mindestens ein Linsendoublett (24, 25) mit mindestens einer, vorzugsweise bikonvexen, Positivlinse (24) und einer unmittelbar nachfolgenden, zur Objektebene konkaven Negativ-Meniskuslinse (25) angeordnet ist.

24. Projektionsobjektiv nach einem der vorhergehenden Ansprüche, bei dem die fünfte Linsengruppe (LG5) mindestens eine Meniskuslinse mit positiver Brechkraft und bildwärts konkaven Linsenflächen aufweist, wobei vorzugsweise aufeinanderfolgend mehrere derartige Meniskuslinsen (26, 27, 28) vorgesehen sind.

25. Projektionsobjektiv nach einem der vorhergehenden Ansprüche, bei dem die fünfte Linsengruppe (LG5) als letztes optisches Element eine Plankonvexlinse (29) aufweist, die vorzugsweise eine sphärische oder asphärisch gekrümmte Eintrittsfläche und eine im Wesentlichen ebene Austrittsfläche hat.

26. Projektionsobjektiv nach Anspruch 25, bei dem die Plankonvexlinse nicht-hemisphärisch ausgebildet ist.

27. Projektionsobjektiv nach einem der vorhergehenden Ansprüche, bei dem auf die fünfte Linsengruppe unmittelbar die Bildebene folgt, so dass das Projektionsobjektiv ausser der ersten bis fünften Linsengruppe keine weitere Linse oder Linsengruppe hat.

28. Projektionsobjektiv nach einem der vorhergehenden Ansprüche, bei dem alle Linsen aus dem gleichen Material bestehen, wobei vorzugsweise als Linsenmaterial für 193nm Arbeitswellenlänge synthetisches Quarzglas oder als Linsenmaterial für 157nm Wellenlänge Kalziumfluorid verwendet wird.

29. Projektionsobjektiv nach einem der vorhergehenden Ansprüche, das eine bildseitige numerische Apertur $NA \geq 1,0$ hat, wobei die bildseitige numerische Apertur vorzugsweise mindestens $NA = 1,1$ oder mindestens $NA = 1,2$ oder mindestens $NA = 1,3$ beträgt.

30. Projektionsobjektiv nach einem der vorhergehenden Ansprüche, wobei das Projektionsobjektiv an ein Immersionsmedium (10) angepasst ist, welches bei einer Arbeitswellenlänge einen Brechungsindex $n > 1,3$ hat.

**31.** Projektionsbelichtungsanlage für die Mikrolithographie, **gekennzeichnet durch** ein refraktives Projektionsobjektiv gemäß einem der vorhergehenden Ansprüche.

**32.** Verfahren zur Herstellung von Halbleiterbauelementen und anderen fein strukturierten Bauteilen mit folgenden Schritten:

Bereitstellung einer Maske mit einem vorgegebenen Muster;
Beleuchtung der Maske mit Ultraviolettlicht einer vorgegebenen Wellenlänge;
Projektion eines Bildes des Musters auf ein im Bereich der Bildebene eines Projektionsobjektivs angeordnetes, lichtempfindliches Substrat mit Hilfe eines Projektionsobjektivs gemäß einem der Ansprüche 1 bis 30;

wobei bei der Projektion ein zwischen einer letzten optischen Fläche des Projektionsobjektives und dem Substrat angeordnetes Immersionsmedium durchstrahlt wird.

**33.** Verfahren zur Herstellung von Halbleiterbauelementen und anderen feinstrukturierten Bauteilen mit folgenden Schritten:

Bereitstellen eine lichtempfindlichen Substrates im Bereich der Bildebene des Projektionsobjektivs;
Beleuchtung der Maske mit Ultraviolettlicht einer vorgegebenen Arbeitswellenlänge;
Einstellen eines endlichen Arbeitsabstandes zwischen einer dem Projektionsobjektiv zugeordneten Austrittsfläche und einer dem Substrat zugeordneten Einkoppelfläche,

wobei der Arbeitsabstand innerhalb eines Belichtungszeitintervalles mindestens zeitweise auf einen Wert eingestellt wird, der kleiner ist als eine maximale Ausdehnung eines optischen Nahfeldes des aus der Austrittsfläche austretenden Lichtes;
Projektion eines Bildes des Musters auf das lichtempfindliche Substrat mit Hilfe des Projektionsobjektivs.

**34.** Verfahren nach Anspruch 33, bei dem mindestens zeitweise ein Arbeitsabstand eingestellt wird, der weniger als das Vierfache der Arbeitswellenlänge beträgt, vorzugsweise wenigstens zeitweise weniger als 50% der Arbeitswellenlänge, insbesondere wenigstens zeitweise ca. 20% oder weniger der Arbeitswellenlänge.

Fig 1

## relativer CHV-Beitrag der Linsen

Linse

Fig. 2

## normierte Brechkräfte der Linsen

Linse

Fig. 3